# EUROPEAN PATENT APPLICATION

(11) **EP 1 865 548 A1**
(43) Date of publication of application: **12.12.2007**
(21) Application number: 06730231.5
(22) Date of filing: 28.03.2006
(51) Int. Cl.: H01L 21/316, H01L 21/31, H01L 21/76

(54) **METHOD FOR PRODUCING SILICON OXIDE FILM, CONTROL PROGRAM THEREOF, RECORDING MEDIUM AND PLASMA PROCESSING APPARATUS**

(30) Priority: 31.03.2005 JP 2005103653
(71) Applicant: TOKYO ELECTRON LIMITED, Minato-ku Tokyo 107-8481 (JP)
(72) Inventor: KITAGAWA, Junichi, TOKYO ELECTRON AT LIMITED, Hyogo 6600891 (JP); FURUI, Shingo, 5780975 (JP)
(74) Representative: HOFFMANN EITLE
(86) International application number: PCT/JP2006/306283
(87) International publication number: WO 2006/106666

(57) **Abstract**

A silicon oxide film formation method includes generating plasma inside a process chamber of a plasma processing apparatus, by use of a process gas having an oxygen ratio of 1% or more, and a process pressure of 133.3 Pa or less; and oxidizing by the plasma a silicon surface exposed inside a recessed part formed in a silicon layer on a target object, thereby forming a silicon oxide film.

## Description

### Technical Field

The present invention relates to a method for forming a silicon oxide film, and more specifically to a method for forming a silicon oxide film that can be applied to, e.g., a case where an oxide film is formed inside a trench used for shallow trench isolation (STI), which is a device isolation technique utilized in the process of manufacturing semiconductor devices.

### Background Art

STI is known as a technique for electrically isolate devices formed on a silicon substrate. According to STI, silicon is etched to form a trench, while a silicon nitride film is used as a mask. Then, an insulating film made of, e.g., SiO₂ is embedded in the trench, and is planarized by a chemical mechanical polishing (CMP) process, while the mask (silicon nitride film) is used as a stopper.

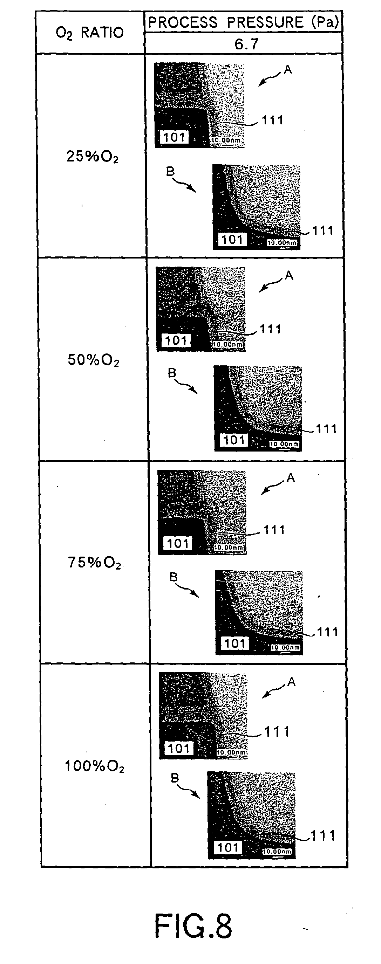

When an STI trench is formed, a shoulder portion of the trench (a corner portion at the upper end of a sidewall of the groove) and/or a nook portion of the trench (the corner portion at the lower end of a sidewall of the groove) may have an acute angle. Consequently, a semiconductor device, such as a transistor, may suffer defects generated due to stress concentration at these portions, whereby a leakage current may be increased, resulting in an increase in power consumption. In order to solve this problem, there is known a technique of performing thermal oxidation on a trench formed by etching, thereby forming an oxide film on an inner wall of the trench to smooth the shape of the trench (for example, Patent Document 1).
[Patent Document 1]
Jpn. Pat. Appln. KOKAI Publication No. 2004-47599 (paragraph No. 0033, FIG. 8, and so forth)

### Disclosure of Invention

Where an oxide film is formed inside a trench by a conventional thermal oxidation method, it is necessary to perform a heat process on a silicon substrate at a high temperature of 1,000°C or more, which corresponds to the viscous flowing point of a silicon oxide film or higher than the point. In this case, problems, such as impurity re-diffusion, may occur, depending on the order of formation of the parts of a semiconductor device.
Specifically, according to a method in which a gate electrode is formed after device isolation is formed by STI, no serious problems arise when a heat process is performed at a high temperature after a trench is formed by etching. However, in recent years, there has been proposed a method in which an impurity diffusion region is formed in a silicon substrate, the multi-layered structure of a gate electrode is further formed, and then these layers are etched together to form a trench for device isolation. In this case, when a heat process is performed to form an oxide film in the trench, problems, such as impurity re-diffusion, may occur.

Further, in the heat process, heat strain may be generated in the silicon substrate due to a high temperature of higher than 1,000°C. This can become more serious problem with an increase in the diameter of silicon substrates in recent years.
Further, silicon substrates have crystal orientation, and formation of an oxide film by thermal oxidation shows crystal orientation dependence. Accordingly, a problem arises such that oxidation rate differs between portions of the inner wall of a trench, and thus can hardly form a uniform oxide film thickness.

In light of the problems described above, an object of the present invention is to provide a method for forming an oxide film on the inner surface of a trench formed in a silicon substrate, without causing problems, such as impurity re-diffusion and/or substrate strain, due to heat. Further, this method can form the oxide film with a rounded shape at the shoulder portion and/or nook portion of the trench and with a uniform thickness on the inner surface.

In order to achieve the object described above, according to a first aspect of the present invention, there is provided a silicon oxide film formation method comprising:
generating plasma inside a process chamber of a plasma processing apparatus, by use of a process gas having an oxygen ratio of 1% or more, and a process pressure of 133.3 Pa or less; and
oxidizing by the plasma a silicon surface exposed inside a recessed part formed on a target object, thereby forming a silicon oxide film.

According to the first aspect, the oxygen ratio in the process gas is set to be 1% (in terms of volume, hereinafter) or more, so that the film quality of the oxide film becomes dense. Further, the film thickness difference depending on portions of the oxide film, particularly the film thickness difference between the upper and lower portions of the recessed part, is solved, so the oxide film is formed with a uniform film thickness. Along with the oxygen ratio described above, the process pressure is set to be 133.3 Pa or less, so that the shoulder portion (silicon corner portion) of the recessed part is rounded to have a curved surface shape. Further, the oxide film has a uniform thickness at the nook portion (corner portion) on the lower side of the recessed part.

In the first aspect, the plasma is preferably generated by use of the process gas and microwaves supplied into the process chamber from a planar antenna having a plurality of slots.

The oxide film may be formed while a curved surface shape is thereby formed on a silicon corner portion at an upper end of a sidewall of the recessed part. In this case, a curvature radius of the curved surface shape may be controlled by a combination of the process pressure with the oxygen ratio in the process gas. The curvature radius of the curved surface shape is preferably controlled to be 4 nm or more.

In the first aspect, the process pressure is preferably set to be 1.3 to 133.3 Pa, and more preferably to be 6.7 to 67 Pa. The oxygen ratio in the process gas is preferably set to be 1 to 100%, and more preferably to be 25 to 100%. The process gas preferably contains hydrogen at a ratio of 0.1 to 10%. The method preferably uses a process temperature of 300 to 1,000°C. The plasma preferably has an electron temperature of 0.5 to 2eV, and preferably has a plasma density of 1×10¹⁰ to 5×10¹² /cm³.

The recessed part may be a trench for shallow trench isolation.
The recessed part may be a recessed part formed in a silicon substrate by etching or may be a recessed part formed in a multi-layered film by etching.

According to a second aspect of the present invention, there is provided a control program for execution on a computer, wherein the control program, when executed by the computer, controls a plasma processing apparatus to conduct a silicon oxide film formation method comprising: generating plasma inside a process chamber of a plasma processing apparatus, by use of a process gas having an oxygen ratio of 1% or more, and a process pressure of 133.3 Pa or less; and oxidizing by the plasma a silicon surface exposed inside a recessed part formed on a target object, thereby forming a silicon oxide film.

According to a third aspect of the present invention, there is provided a computer readable storage medium that stores a control program for execution on a computer, wherein the control program, when executed by the computer, controls a plasma processing apparatus to conduct a silicon oxide film formation method comprising: generating plasma inside a process chamber of a plasma processing apparatus, by use of a process gas having an oxygen ratio of 1% or more, and a process pressure of 133.3 Pa or less; and oxidizing by the plasma a silicon surface exposed inside a recessed part formed on a target object, thereby forming a silicon oxide film.

According to a fourth aspect of the present invention, there is provided a plasma processing apparatus comprising:
a plasma supply source configured to generate plasma;
a process chamber configured to be vacuum-exhausted and to process a target object by the plasma; and
a control section configured to control the apparatus to conduct a silicon oxide film formation method comprising, generating plasma inside the process chamber by use of a process gas having an oxygen ratio of 1% or more, and a process pressure of 133.3 Pa or less, and oxidizing by the plasma a silicon surface exposed inside a recessed part formed on the target object, thereby forming a silicon oxide film.

According to the present invention, an oxide film is formed by use of plasma with an oxygen ratio of 1% or more and a process pressure of 133.3 Pa or less, so that the oxide film is formed with a uniform film thickness in a recessed part, such as a trench, and the shoulder portion of the recessed part is rounded to have a curved surface shape (rounded shape). The rounding degree (curvature radius) can be controlled by the oxygen ratio and the process pressure. Accordingly, where an oxide film is formed after an STI trench or the like is formed, the recessed part is formed to have a rounded shape at the shoulder portion and nook portion thereof with high precision and without causing problems, such as impurity re-diffusion and/or substrate strain, as in thermal oxidation. Where a semiconductor device (such as an MOS transistor) is provided with a device isolation region comprising a recessed part and an oxide film formed by this method, the device can suppress the leakage current and realize power saving, as needed.

### Brief Description of Drawings

[FIG. 1] This is a sectional view schematically showing an example of a plasma processing apparatus suitable for performing a method according to the present invention.
[FIG. 2] This is a view showing the structure of a planar antenna member.
[FIG. 3A] This is a view schematically showing a cross-section of a wafer before it is processed.
[FIG. 3B] This is a view schematically showing the cross-section of the wafer with a silicon oxide film formed thereon.
[FIG. 3C] This is a view schematically showing the cross-section of the wafer with a silicon nitride film formed thereon.
[FIG. 3D] This is a view schematically showing the cross-section of the wafer with a resist layer formed thereon.
[FIG. 3E] This is a view schematically showing the cross-section of the wafer with silicon exposed thereon.
[FIG. 3F] This is a view schematically showing the cross-section of the wafer after it is processed by ashing.
[FIG. 3G] This is a view schematically showing the cross-section of the wafer with a trench formed in the silicon substrate.
[FIG. 3H] This is a view schematically showing the cross-section of the wafer with the inner wall of the trench being subjected to a plasma oxidation process.
[FIG. 31] This is a view schematically showing the cross-section of the wafer after it is processed by the plasma oxidation process.

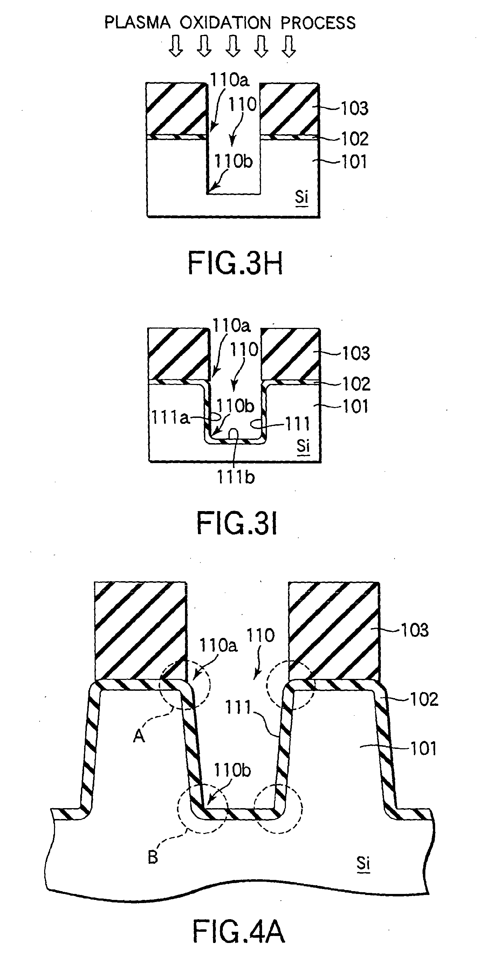

[FIG. 4A] This is a view schematically showing a cross-section of a wafer with an oxide film formed thereon by a method according to the present invention.

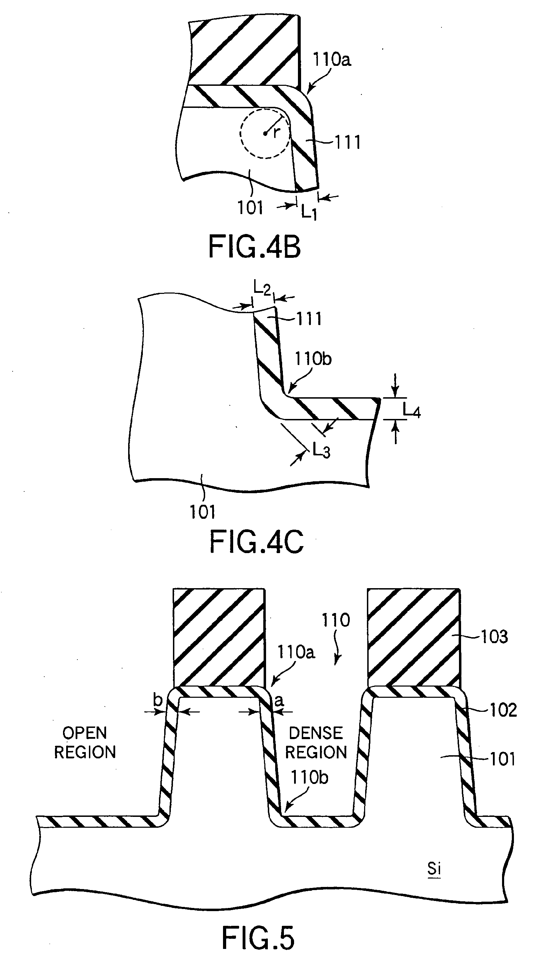

[FIG. 4B] This is an enlarged view of a portion A in FIG. 4A.
[FIG. 4C] This is an enlarged view of a portion B in FIG. 4A.

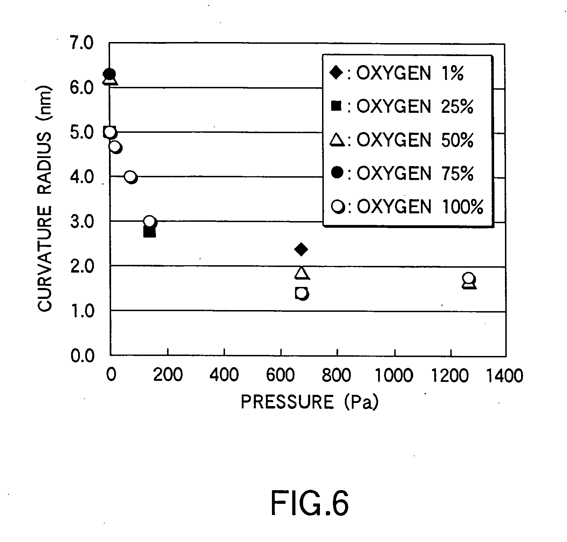

[FIG. 5] This is a view schematically showing a cross-section of a wafer for explaining the film thickness at the open region and dense region of a pattern.
[FIG. 6] This is a graph plotting the relationship between the pressure of a plasma process and curvature radius.

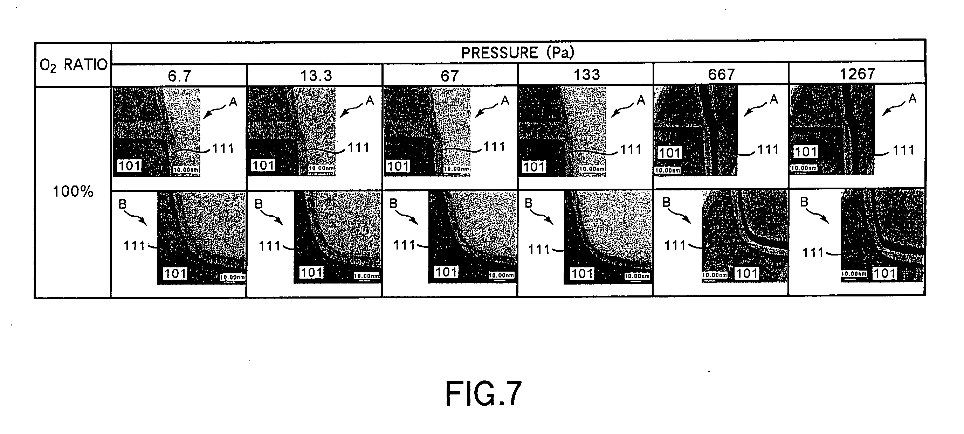

[FIG. 7] This is a view showing TEM pictures of an upper portion and a lower portion of a trench obtained when an oxidation process was performed with an oxygen ratio of 100%.
[FIG. 8] This is a view showing TEM pictures of an upper portion and a lower portion of a trench obtained when a process was performed at a pressure of 6.7 Pa.

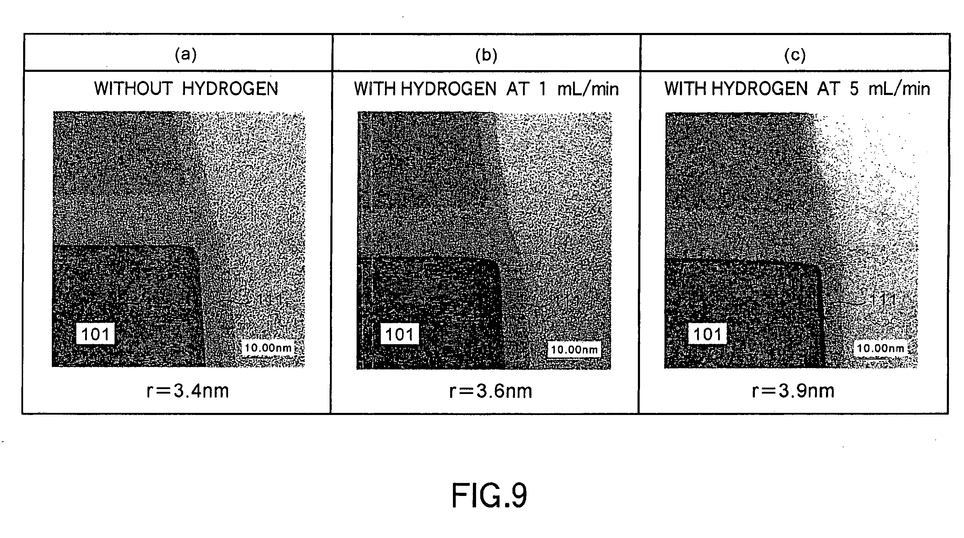

[FIG. 9] This is a view showing TEM pictures of an upper portion of a trench.

### Best Mode for Carrying Out the Invention

A preferable embodiment of the present invention will now be described with reference to the accompanying drawings.

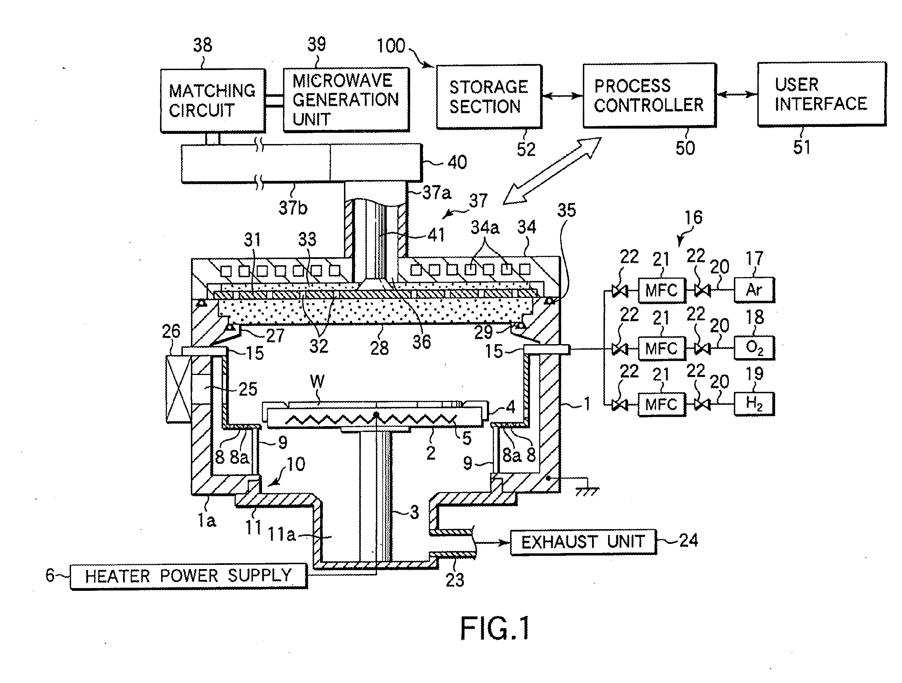

FIG. 1 is a sectional view schematically showing an example of a plasma processing apparatus suitable for performing a plasma oxidation method according to the present invention. This plasma processing apparatus is arranged as a plasma processing apparatus, in which microwaves are supplied from a planar antenna having a plurality of slots into a process chamber to generate microwave plasma with a high density and a low electron temperature. Particularly, this plasma processing apparatus employs an RLSA (Radial Line Slot Antenna) as the planar antenna and thus is formed of the RLSA microwave plasma type. For example, this apparatus is preferably used for a process for forming an oxide film on an inner wall of an STI trench.

This plasma processing apparatus 100 includes an essentially cylindrical chamber 1, which is airtight and grounded. The bottom wall 1a of the chamber 1 has a circular opening portion 10 formed essentially at the center, and is provided with an exhaust chamber 11 communicating with the opening portion 10 and extending downward.

The chamber 1 is provided with a susceptor 2 located therein and made of a ceramic, such as AlN, for supporting a target substrate, such as a semiconductor wafer (which will be referred to as "wafer" hereinafter) W, in a horizontal state. The susceptor 2 is supported by a cylindrical support member 3 made of a ceramic, such as A1N, and extending upward from the center of the bottom of the exhaust chamber 11. The susceptor 2 is provided with a guide ring 4 located on the outer edge to guide the wafer W. The susceptor 2 is further provided with a heater 5 of the resistance heating type built therein. The heater 5 is supplied with a power from a heater power supply 6 to heat the susceptor 2, thereby heating the target object or wafer W. For example, the heater 5 can control the temperature within a range of from about room temperature to 800°C. A cylindrical liner 7 made of quartz is attached along the inner wall of the chamber 1. The outer periphery of the susceptor 2 is surrounded by an annular baffle plate 8 made of quartz, which is supported by a plurality of support members 9. The baffle plate 8 has a number of exhaust holes 8a and allows the interior of the chamber 1 to be uniformly exhausted.

The susceptor 2 is provided with wafer support pins (not shown) that can project and retreat relative to the surface of the susceptor 2 to support the wafer W and move it up and down.

A gas feed member 15 having an annular structure with gas spouting holes uniformly distributed is attached in the sidewall of the chamber 1. The gas feed member 15 is connected to a gas supply system 16. The gas feed member may have a shower structure. For example, the gas supply system 16 includes an Ar gas supply source 17, an O₂ gas supply source 18, and an H₂ gas supply source 19. These gases are supplied from the sources through respective gas lines 20 to the gas feed member 15 and are delivered from the gas spouting holes of the gas feed member 15 uniformly into the chamber 1. Each of the gas lines 20 is provided with a mass-flow controller 21 and two switching valves 22 one on either side of the controller 21. In place of Ar gas, another rare gas, such as Kr, He, Ne, or Xe gas, may be used. Alternatively, no rare gas may be contained, as described later.

The sidewall of the exhaust chamber 11 is connected to an exhaust unit 24 including a high speed vacuum pump through an exhaust line 23. The exhaust unit 24 can be operated to uniformly exhaust gas from inside the chamber 1 into the space 11a of the exhaust chamber 11, and then out of the exhaust chamber 11 through the exhaust line 23. Consequently, the inner pressure of the chamber 1 can be decreased at a high speed to a predetermined vacuum level, such as 0.133 Pa.

The chamber 1 has a transfer port 25 formed in the sidewall and provided with a gate valve 26 for opening/closing the transfer port 25. The wafer W is transferred between the plasma processing apparatus 100 and an adjacent transfer chamber (not shown) through the transfer port 25.

The top of the chamber 1 is opened and is provided with an annular support portion 27 along the periphery of the opening portion. A microwave transmission plate 28 is airtightly mounted on the support portion 27 through a seal member 29. The microwave transmission plate 28 is made of a dielectric material, such as quartz or a ceramic, e.g., Al₂O₃, to transmit microwaves. The interior of the chamber 1 is thus held airtight.

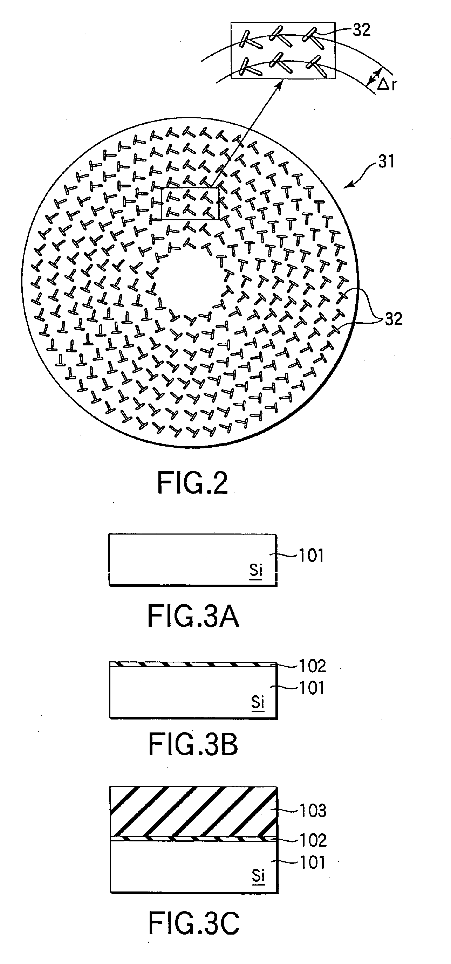

A circular planar antenna member 31 is located above the microwave transmission plate 28 to face the susceptor 2. The planar antenna member 31 is fixed on the upper end of the sidewall of chamber 1. The planar antenna member 31 is a circular plate made of a conductive material, and is formed to have, e.g., a diameter of 300 to 400 mm and a thickness of 1 to several mm (for example, 5 mm) for 8-inch wafers W. Specifically, the planar antenna member 31 is formed of, e.g., a copper plate or aluminum plate with the surface plated with silver or gold. The planar antenna member 31 has a number of microwave radiation holes (slots) 32 formed therethrough and arrayed in a predetermined pattern. For example, as shown in FIG. 2, the microwave radiation holes 32 are formed of long slits, wherein the microwave radiation holes 32 are typically arranged such that adjacent holes 32 form a T-shape while they are arrayed on a plurality of concentric circles. The length and array intervals of the microwave radiation holes 32 are determined in accordance with the wavelength (λg) of microwaves. For example, the intervals of the microwave radiation holes 32 are set to be λg/4, λg/2, or λg. In FIG. 2, the interval between adjacent microwave radiation holes 32 respectively on two concentric circles is expressed with Δr. The microwave radiation holes 32 may have another shape, such as a circular shape or arc shape. The array pattern of the microwave radiation holes 32 is not limited to a specific one, and, for example, it may be spiral or radial other than concentric.

A wave-retardation body 33 made of a resin, such as polytetrafluoroethylene or polyimide, having a dielectric constant larger than that of vacuum is disposed on the top of the planar antenna member 31. The wave-retardation body 33 shortens the wavelength of microwaves to adjust plasma, because the wavelength of microwaves becomes longer in a vacuum condition. The planar antenna member 31 may be set in contact with or separated from the microwave transmission plate 28. Similarly, the wave-retardation body 33 may be set in contact with or separated from the planar antenna member 31.

The planar antenna member 31 and wave-retardation body 33 are covered with a shield lid 34 located at the top of the chamber 1. The shield lid 34 is made of a metal material, such as aluminum, stainless steel, or copper. A seal member 35 is interposed between the top of the chamber 1 and the shield lid 34 to seal this portion. The shield lid 34 is provided with cooling water passages 34a formed therein. Cooling water is supplied to flow through the cooling water passages 34a and thereby cool the shield lid 34, wave-retardation body 33, planar antenna member 31, and microwave transmission plate 28. The shield lid 34 is grounded.

The shield lid 34 has an opening portion 36 formed at the center of the upper wall and connected to a wave guide tube 37. The wave guide tube 37 is connected to a microwave generation unit 39 at one end through a matching circuit 38. The microwave generation unit 39 generates microwaves with a frequency of, e.g., 2.45 GHz, which are transmitted through the wave guide tube 37 to the planar antenna member 31. The microwaves may have a frequency of 8.35 GHz or 1.98 GHz.

The wave guide tube 37 includes a coaxial wave guide tube 37a having a circular cross-section and extending upward from the opening portion 36 of the shield lid 34. The wave guide tube 37 further includes a rectangular wave guide tube 37b connected to the upper end of the coaxial wave guide tube 37a through a mode transducer 40 and extending in a horizontal direction. The mode transducer 40 interposed between the rectangular wave guide tube 37b and coaxial wave guide tube 37a serves to convert microwaves propagated in a TE mode through the rectangular wave guide tube 37b into a TEM mode. The coaxial wave guide tube 37a includes an inner conductive body 41 extending at the center, which is connected and fixed to the center of the planar antenna member 31 at the lower end. With this arrangement, microwaves are efficiently and uniformly propagated through the inner conductive body 41 of the coaxial wave guide tube 37a to the planar antenna member 31.

The respective components of the plasma processing apparatus 100 are connected to and controlled by a process controller 50 comprising a CPU. The process controller 50 is connected to a user interface 51 including, e.g. a keyboard and a display, wherein the keyboard is used for a process operator to input commands for operating the plasma processing apparatus 100, and the display is used for showing visualized images of the operational status of the plasma processing apparatus 100.

Further, the process controller 50 is connected to a storage section 52 that stores recipes containing control programs (software), process condition data, and so forth recorded therein, for the process controller 50 to control the plasma processing apparatus 100 so as to perform various processes.

A required recipe is retrieved from the storage section 52 and executed by the process controller 50 in accordance with an instruction or the like input through the user interface 51. Consequently, the plasma processing apparatus 100 can perform a predetermined process under the control of the process controller 50. The recipes containing control programs and process condition data may be used while they are stored in a computer readable storage medium, such as a CD-ROM, hard disk, flexible disk, or flash memory. Alternatively, the recipes may be used online while they are transmitted from another apparatus through, e.g., a dedicated line, as needed.

The plasma processing apparatus 100 thus structured can proceed with a plasma process free from damage even at a low temperature of 800°C or less. Accordingly, this apparatus 100 can provide a film of high quality, while maintaining good plasma uniformity to realize good process uniformity.

As described above, this plasma processing apparatus 100 can be preferably used for an oxidation process performed on an inner wall of an STI trench or the like. When an oxidation process of a trench is performed in the plasma processing apparatus 100, the gate valve 26 is first opened, and a wafer W having a trench formed thereon is transferred through the transfer port 25 into the chamber 1 and placed on the susceptor 2.

Then, Ar gas and O₂ gas are supplied at predetermined flow rates from the Ar gas supply source 17 and O₂ gas supply source 18 in the gas supply system 16 through the gas feed member 15 into the chamber 1, while it is maintained at a predetermined pressure. As conditions used as this time, the ratio of oxygen in the process gas is set to be 1 to 100%, preferably 25% or more, more preferably 75% or more, and furthermore preferably 95% or more. The gas flow rates are selected from a range of Ar gas of 0 to 2,000 mL/min and a range of O₂ gas of 10 to 500 mL/min to set the ratio of oxygen relative to the total gas flow rate at a value as described above. The partial pressure of O₂ gas in the process gas is preferably set to be 0.0133 Pa to 133.3 Pa, and more preferably to be 6.7 to 133.3 Pa.

Further, in addition to Ar gas and O₂ gas from the Ar gas supply source 17 and O₂ gas supply source 18, H₂ gas may be supplied at a predetermined ratio from the H₂ gas supply source 19. In this case, the ratio of H₂ relative to the total of the process gas is preferably set to be 0.1 to 10%, more preferably to be 0.1 to 5%, and furthermore preferably to be 0.1 to 2%.

The process pressure inside the chamber may be selected from a range of 1.3 to 133.3 Pa, preferably of 6.7 to 133.3 Pa, more preferably of 6.7 to 67 Pa, furthermore preferably of 6.7 to 13.3 Pa. The process temperature may be selected from a range of 300 to 1,000°C, preferably of 700 to 1,000°C, and more preferably of 700 to 800°C.

Then, microwaves are supplied from the microwave generation unit 39 through the matching circuit 38 into the wave guide tube 37. The microwaves are supplied through the rectangular wave guide tube 37b, mode transducer 40, and coaxial wave guide tube 37a in this order to the planar antenna member 31. Then, the microwaves are radiated from the planar antenna member 31 through the microwave transmission plate 28 into the space above the wafer W within the chamber 1. The microwaves are propagated in a TE mode through the rectangular wave guide tube 37b, and are then converted from the TE mode into a TEM mode by the mode transducer 40 and propagated in the TEM mode through the coaxial wave guide tube 37a to the planar antenna member 31. At this time, the power applied to the microwave generation unit 39 is preferably set to be 0.5 to 5 kW.

When the microwaves are radiated from the planar antenna member 31 through the microwave transmission plate 28 into the chamber 1, an electromagnetic field is generated inside the chamber 1. Consequently, Ar gas and O₂ gas are turned into plasma, by which oxidation is performed on the exposed silicon surface inside recessed parts formed on the wafer W. Since microwaves are radiated from a number of microwave radiation holes 32 of the planar antenna member 31, this microwave plasma has a high plasma density of about 1×10¹⁰ to 5×10¹² /cm³ or more, an electron temperature of about 0.5 to 2 eV, and a plasma density uniformity of ±5% or less. Accordingly, this plasma has merits such that a thin oxide film can be formed at a low temperature and in a short time, and the oxide film can suffer less damage due to ions and so forth in plasma, so as to have high quality.

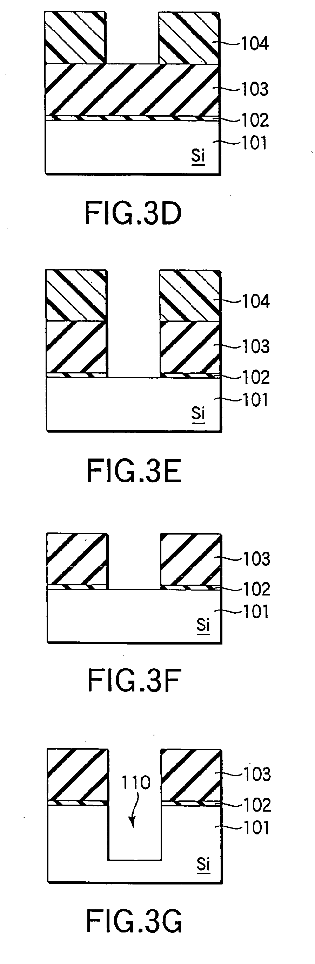

Next, with reference to FIGS. 3A to 3I, 4, and 5, an explanation will be given of a case where a method for forming a silicon oxide film according to the present invention is applied to an oxidation process inside an STI trench formed by etching. FIGS. 3A to 3I are views showing steps from formation of an STI trench to formation of an oxide film subsequently performed. At first, as shown in FIGS. 3A and 3B, a silicon oxide film 102, such as SiO₂, is formed on a silicon substrate 101 by, e.g., thermal oxidation. Then, as shown in FIG. 3C, a silicon nitride film 103, such as Si₃N₄, is formed on the silicon oxide film 102 by, e.g., CVD (Chemical Vapor Deposition). Further, as shown in FIG. 3D, a photo-resist coating layer is formed on the silicon nitride film 103, and is subjected to patterning by a photolithography technique to form a resist layer 104.

Then, while the resist layer 104 is used as an etching mask, selective etching is performed on the silicon nitride film 103 and silicon oxide film 102 by use of, e.g., a'halogen-containing etching gas, so that a part of the silicon substrate 101 is exposed in accordance with the pattern of the resist layer 104 (FIG. 3E). Consequently, the silicon nitride film 103 forms a mask pattern for a trench. FIG. 3F shows a state after the resist layer 104 is removed by a so-called ashing process using oxygen-containing plasma generated from a process gas containing, e.g., oxygen.

As shown in FIG. 3G, while the silicon nitride film 103 and silicon oxide film 102 are used as a mask, selective etching is performed on the silicon substrate to form a trench 110. For example, this etching may be performed by use of an etching gas containing a halogen or halogen compound, such as Cl₂ HBr, SF₆, or CF₄, or containing O₂.

FIG. 3H shows an oxidation step in which a plasma oxidation process is performed on the STI trench 110 formed by etching in the wafer W. Where this oxidation step is performed under conditions described below, the shoulder portion 110a of the trench 110 is rounded, and an oxide film 111 is formed with a uniform film thickness on the inner surface of the trench 110, as shown in FIG. 3I.

The process gas used in the oxidation step is required to contain O₂ by 1% or more, and thus may comprise a mixture gas of O₂ and a rare gas, for example. However, the process gas may contain no rare gas. In place of O₂, NO gas, NO₂ gas, or N₂O gas may be used. Where the ratio (percentage) of oxygen relative to the total process gas is set to be 1 to 100%, the film quality of the oxide film 111 becomes dense. Further, in this case, the film thickness difference depending on portions of the trench 110, particularly the film thickness difference between portions near the corners on the upper and lower sides of the trench, is solved, so the oxide film 111 is formed with a uniform film thickness.
Since a higher O₂ content in the process gas is more effective, this content is preferably set to be 50% or more, more preferably to be 75% or more, and furthermore preferably to be 95% or more. In conclusion, the O₂ content in the process gas is set to be, e.g., 1 to 100% in a broad sense, preferably to be 25 to 100%, more preferably to be 50 to 100%, furthermore preferably to be 75 to 100%, and most preferably to be 95 to 100%.
As described above, the partial pressure of oxygen in the process gas is adjusted to control the quantity of oxygen ions and/or oxygen radicals in plasma, and thereby to further control the quantity of oxygen ions and/or oxygen radicals that enter the trench 110. Consequently, the corner portions of the trench 110 are rounded, and a silicon oxide film is uniformly formed inside the trench 110,

Further, the process gas may contain H₂ gas at a predetermined ratio in addition to O₂ gas. In this case, the ratio of H₂ relative to the total of the process gas may be selected from a range of 10% or less, e.g., 0.1 to 10%, and preferably of 0.5 to 5%.

The pressure used in the oxidation step is preferably set to be 1.3 to 133.3 Pa, and more preferably to be 6.7 to 133.3 Pa. Where the process pressure is set to be 133.3 Pa or less along with the O₂ ratio described above, the shoulder portion 110a of the trench (silicon corner portion) is rounded to have a curved surface shape. Particularly, as compared to a higher pressure (for example, higher than 133.3 Pa), a lower pressure of 13.3 Pa or less brings about a higher ion energy in plasma, and thereby increases the oxidation action by ions, i.e., increases the oxidation rate. In this case, it is thought that, since the difference in oxidation rate between the corner portion and flat portion becomes smaller, oxidation is uniformly developed on the silicon corner at the shoulder portion 110a of the trench 110, so the silicon corner is rounded to have a curved surface shape. The rounding degree (curvature radius r) of the shoulder portion 110a can be controlled by the O₂ content in the process gas and the process pressure, such that the process pressure is set to be 133.3 Pa or less and the O₂ content is set to be 1% or more. In order to decrease the leakage current of a semiconductor device, the curvature radius r of the shoulder portion 110a is preferably set to be 2.8 nm or more, and more preferably set to be 4 to 8 nm.

Further, where the process is performed while the oxygen content in the process gas is set to be 25% or more and the pressure is set to be 13.3 Pa or less, the oxide film 111 is formed to have a uniform film thickness on a region at and around a lower corner portion 110b of the trench 110 (round region), e.g., portions indicted with reference symbols 111a and 111b in FIG. 3I.

FIG. 4A is a view schematically showing a cross-section of a main portion of a wafer W with an oxide film 111 formed thereon by a method for forming a silicon oxide film according to the present invention. FIG. 4B is an enlarged view of a portion A indicated with a broken line in FIG. 4A, and FIG. 4C is an enlarged view of a portion B indicated with a broken line in FIG. 4A.
As shown in FIGS. 4A and 4B, the shoulder portion 110a of a trench 110 is formed to have a curved surface with a curvature radius r of the rounded inner silicon 101 set to be, e.g., 4 nm or more. Further, as shown in FIGS. 4A and 4C, the oxide film 111 is formed to have an essentially uniform film thickness on a region at and around a lower corner portion 110b of the trench 110 (round region), such that the film thickness L3 at the corner portion 110b is essentially equal to the film thicknesses L2 and L4 near the boundaries adjacent to the linear portions on both sides of the corner portion 110b. In addition, the film thickness L1 at the upper portion of the sidewall of the trench 110 is essentially equal to the film thickness L2 at the lower portion of the sidewall. Accordingly, the oxide film 111 is formed to solve the film thickness difference depending on portions of the trench 110.

Further, where the plasma oxidation process is performed under the conditions described above, a silicon oxide film is formed with a decreased difference in film thickness between the open region and dense region of a pattern on the surface of a wafer W. Specifically, for example, as shown in FIG. 5, the oxide film thickness (indicated with a reference symbol a) on a region with a higher density (dense region) of a pattern and the oxide film thickness (indicated with a reference symbol b) on a region with a lower density (open region) thereof can be essentially equal to each other.

After the oxide film 111 is formed by a method for forming a silicon oxide film according to the present invention, subsequent steps of STI for forming a device isolation region are performed. For example, an insulating film of, e.g., SiO₂ is formed by a CVD method to fill the trench 110, and is then polished and planarized by means of CMP, while the silicon nitride film 103 is used as a stopper layer. After the planarization, the upper portions of the silicon nitride film 103 and embedded insulating film are removed by etching to form a device isolation structure.

Next, an explanation will be given of results of an experiment performed to confirm effects of the present invention.
In the plasma processing apparatus 100 shown in FIG. 1, an oxidation process was performed, under different values of the process pressure, on a trench formed by etching in an STI process for forming a device isolation region. In this experiment, the process pressure was set at different values of 6.7 Pa (50 mTorr), 13.3 Pa (100 mTorr), 67 Pa (500 mTorr), 133.3 Pa (1 Torr), 667 Pa (5 Torr), and 1,267 Pa (9.5 Torr). The process gas of the plasma oxidation process comprised Ar gas and O₂ gas, while the ratio of O₂ gas relative to the total process gas was set at different values of 1%, 25%, 50%, 75%, and 100% (O₂ alone).

The oxygen ratio was adjusted to set the total flow rate of the process gas at 500 mL/min (sccm). the process temperature (substrate process temperature) was set at 400°C. The power applied to plasma was set at 3.5 kW. The process film thickness was set at 8 nm.

After the oxidation process, the thickness of the oxide film 111 at respective portions of the trench and the curvature radius of the trench shoulder portion 110a were measured on the basis of picked up images of cross-sections obtained by a transmission electron microscopy (TEM) photography.
Table 1 shows measurement results of the curvature radius r of the trench shoulder portion 110a. Since the rounding degree tends to be larger with an increase in the thickness of the oxide film 111, Table 1 shows a normalized value of the curvature radius r (nm) relative to the oxide film thickness L (nm) [curvature radius r/oxide film thickness L × 100] on the upper side, while it shows a value of the curvature radius r on the lower side. Table 2 shows the ratio in oxide film thickness between the upper and lower portions of the trench (the film thickness on the upper portion/the film thickness on the lower portion). Further, FIG. 6 is a graph showing the relationship between the pressure and curvature radius in this experiment. As shown in Table 1 and FIG. 6, where the process pressure was 133.3 Pa or less, a curvature radius of 2.8 nm or more was obtained even if the oxygen ratio was 1%.
FIG. 7 is a view showing transmission electron microscopy (TEM) pictures of an upper portion and a lower portion of a trench obtained by each of different pressures when the oxygen ratio was set at 100%. FIG. 8 is a view showing TEM pictures of an upper portion and a lower portion of a trench obtained by each of different oxygen ratios when the process pressure was set at 6.7 Pa. In FIGS. 7 and 8, reference symbols A and B indicate that these portions correspond to the reference symbols A and B in FIG. 4A, respectively.

**[Table 1]**

| O₂ flow rate ratio | Pressure (Pa) | | | | | |
|---|---|---|---|---|---|---|
| | 6.7 | 13.3 | 67 | 133 | 667 | 1267 |
| 1% | | | | 35 (2.8) | 33 (2.4) | |
| 25% | 75 (5.0) | | | 35 (2.8) | 16 (1.4) | |
| 50% | 96 (6.3) | | | | 25 (1.9) | 21 (1.7) |
| 75% | 83 (6.3) | | | | | |
| 100% | 83 (5.0) | 72 (4.7) | 59 (4.0) | 50 (3.0) | 20 (1.4) | 21 (1.8) |

| | | | | | | |
|---|---|---|---|---|---|---|
| Upper side: Normalized value relative to film thickness Lower side: Curvature radius (measure: nm) | | | | | | |

**[Table 2]**

| O₂ flow rate ratio | Pressure(Pa) | | | | | |
|---|---|---|---|---|---|---|
| | 6.7 | 13.3 | 67 | 133 | 667 | 1267 |
| 1% | | | | 0.81 | 0.76 | |
| 25% | 0.92 | | | 0.75 | 0.66 | |
| 50% | 0.92 | | | | 0.81 | 0.73 |
| 75% | 0.80 | | | | | |
| 100% | 1.04 | 0.99 | 0.74 | 0.63 | 0.99 | 0.97 |

As shown in Table 1 and FIGS. 7 and 8, the curvature radius of the trench shoulder portion 110a tended to be larger under conditions with an oxygen ratio of 25% or more and a pressure of 133.3 Pa or less, and, particularly, it was remarkably larger when the pressure was 67 Pa or less.
Further, as shown in Table 2 and FIGS. 7 and 8, for example, where the oxygen ratio was 100%, the film thickness difference of the oxide film 111 between the upper and lower portions was largest near 133.3 Pa and tended to be gradually smaller with a decrease in pressure from 133.3 Pa. Where the pressure was 13.3 Pa or less, the film thickness difference was essentially solved.
Accordingly, where the plasma oxidation process is performed on the inside of an STI trench, the oxygen ratio in the process gas is set to be within a preferable range of 1 to 100%, and the process pressure is controlled within a range of 1.33 to 133.3 Pa, so that an oxide film is formed preferably with a uniform thickness and rounded corner portions.

Then, in the plasma processing apparatus 100 shown in FIG. 1, a plasma process was performed on an STI trench formed by etching. At this time, the process gas flow rate was set at Ar/O₂ = 500/5 mL/min (sccm). The hydrogen flow rate was set at different values of 0 (not added), 1 mL/min (sccm), and 5 mL/min (sccm). Then, the curvature radius of the shoulder portion 110a of the trench thus formed was measured on the basis of a TEM picture of a cross-section of the wafer W.

In this plasma oxidation process, the process temperature (substrate process temperature) was set at 400°C. The power applied to plasma was set at 2,750W. The process pressure was set at 133.3 Pa (1 Torr).

After the oxidation process, the curvature radius of the trench shoulder portion 110a was measured on the basis of picked up images of cross-sections obtained by a transmission electron microscopy (TEM) photography. FIG. 9 is a view showing measurement results of the curvature radius of the trench shoulder portion 110a. As shown in FIG. 9, where hydrogen was added, the curvature radius r was larger, and the trench shoulder portion 110a was more rounded. Accordingly, where the plasma oxidation process is performed on the inside of an STI trench, the process gas is prepared to contain H₂ at a ratio of 10% or less, preferably of 0.5 to 5%, and more preferably of 1 to 2%, so that the rounded shape of the corner portion is optimized.

The present invention has been described with reference to an embodiment, but the present invention is not limited to the embodiment described above, and it may be modified in various manners. For example, in FIG. 1, the microwave plasma processing apparatus 100 is arranged to excite plasma by microwaves with a frequency of 300 MHz to 300 GHz. Alternatively, an RF (Radio Frequency) plasma processing apparatus arranged to excite plasma by an RF with a frequency of 30 kHz to 300 MHz may be used.
Further, the plasma processing apparatus 100 is exemplified by the RLSA type. Alternatively, a plasma processing apparatus of another type, such as the remote plasma type, ICP plasma type, ECR plasma type, surface reflection-wave plasma type, or magnetron plasma type, may be used.

Further, the embodiment described above is exemplified by a case where an oxide film is formed inside an STI trench. Alternatively, the present invention may be applied to a case where a corner portion of a poly-silicon electrode formed by etching is rounded in a device manufacturing step, such as oxidation of a side surface of a poly-silicon gate electrode formed by etching.

### Industrial Applicability

The present invention is preferably utilized for forming device isolation by, e.g., STI in manufacturing various semiconductor devices.

## Claims

1. A silicon oxide film formation method comprising:
generating plasma inside a process chamber of a plasma processing apparatus, by use of a process gas having an oxygen ratio of 1% or more, and a process pressure of 133.3 Pa or less; and
oxidizing by the plasma a silicon surface exposed inside a recessed part formed on a target object, thereby forming a silicon oxide film.

2. The silicon oxide film formation method according to claim 1, wherein the plasma is generated by use of the process gas and microwaves supplied into the process chamber from a planar antenna having a plurality of slots.

3. The silicon oxide film formation method according to claim 1, wherein the oxide film is formed while a curved surface shape is thereby formed on a silicon corner portion at an upper end of a sidewall of the recessed part.

4. The silicon oxide film formation method according to claim 3, wherein a curvature radius of the curved surface shape is controlled by a combination of the process pressure with the oxygen ratio in the process gas.

5. The silicon oxide film formation method according to claim 4, wherein the curvature radius of the curved surface shape is controlled to be 4 nm or more.

6. The silicon oxide film formation method according to claim 1, wherein the process pressure is set to be 1.3 to 133.3 Pa.

7. The silicon oxide film formation method according to claim 1, wherein the process pressure is set to be 6.7 to 67 Pa.

8. The silicon oxide film formation method according to claim 1, wherein the oxygen ratio in the process gas is set to be 1 to 100%.

9. The silicon oxide film formation method according to claim 1, wherein the oxygen ratio in the process gas is set to be 25 to 100%.

10. The silicon oxide film formation method according to claim 1, wherein the process gas contains hydrogen at a ratio of 0.1 to 10%.

11. The silicon oxide film formation method according to claim 1, wherein the method uses a process temperature of 300 to 1,000°C.

12. The silicon oxide film formation method according to claim 1, wherein the plasma has an electron temperature of 0.5 to 2eV.

13. The silicon oxide film formation method according to claim 1, wherein the plasma has a plasma density of 1×10¹⁰ to 5×10¹² /cm³.

14. The silicon oxide film formation method according to claim 1, wherein the recessed part is a trench for shallow trench isolation.

15. The silicon oxide film formation method according to claim 1, wherein the recessed part is a recessed part formed in a silicon substrate by etching.

16. The silicon oxide film formation method according to claim 1, wherein the recessed part is a recessed part formed in a multi-layered film by etching.

17. A control program for execution on a computer, wherein the control program, when executed by the computer, controls a plasma processing apparatus to conduct a silicon oxide film formation method comprising: generating plasma inside a process chamber of a plasma processing apparatus, by use of a process gas having an oxygen ratio of 1% or more, and a process pressure of 133.3 Pa or less; and oxidizing by the plasma a silicon surface exposed inside a recessed part formed on a target object, thereby forming a silicon oxide film.

18. A computer readable storage medium that stores a control program for execution on a computer, wherein the control program, when executed by the computer, controls a plasma processing apparatus to conduct a silicon oxide film formation method comprising: generating plasma inside a process chamber of a plasma processing apparatus, by use of a process gas having an oxygen ratio of 1% or more, and a process pressure of 133.3 Pa or less; and oxidizing by the plasma a silicon surface exposed inside a recessed part formed on a target object, thereby forming a silicon oxide film.

19. A plasma processing apparatus comprising:
a plasma supply source configured to generate plasma;
a process chamber configured to be vacuum-exhausted and to process a target object by the plasma; and
a control section configured to control the apparatus to conduct a silicon oxide film formation method comprising, generating plasma inside the process chamber by use of a process gas having an oxygen ratio of 1% or more, and a process pressure of 133.3 Pa or less, and oxidizing by the plasma a silicon surface exposed inside a recessed part formed on the target object, thereby forming a silicon oxide film.
